# EUROPEAN PATENT APPLICATION

(11) **EP 2 348 546 A2**
(43) Date of publication of application: **27.07.2011**
(21) Application number: 11151994.8
(22) Date of filing: 25.01.2011
(51) Int. Cl.: H01L 31/18, H01L 31/0236, H01L 21/225

(54) **Composition for forming n-type diffusion layer, method for forming n-type diffusion layer, and method for producing photovoltaic cell**

(30) Priority: 25.01.2010 JP 2010013517; 16.09.2010 JP 2010208429; 13.01.2011 JP 2011005313
(71) Applicant: Hitachi Chemical Co., Ltd., Tokyo 163-0449 (JP)
(72) Inventor: Machii, Youichi, Ibaraki 300-4247 (JP); Yoshida, Masato, Ibaraki 300-4247 (JP); Nojiri, Takeshi, Ibaraki 300-4247 (JP); Okaniwa, Kaoru, Ibaraki 300-4247 (JP); Iwamuro, Mitsunori, Ibaraki 300-4247 (JP); Adachi, Shuuichirou, Ibaraki 300-4247 (JP); Aoyagi, Takuya, Ibaraki 319-1292 (JP)
(74) Representative: HOFFMANN EITLE

(57) **Abstract**

The composition for forming an n-type diffusion layer in accordance with the present invention contains a donor element-containing glass powder and a dispersion medium. An n-type diffusion layer and a photovoltaic cell having an n-type diffusion layer are prepared by applying the composition for forming an n-type diffusion layer, followed by a thermal diffusion treatment.

## Description

### BACKGROUND OF THE INVENTION

### Field of the Invention

The present invention relates to a composition for forming an n-type diffusion layer of a photovoltaic cell, a method for forming an n-type diffusion layer, a method for producing a photovoltaic cell, a paste composition and a use of the composition. More specifically, the present invention relates to a technique which enables the formation of an n-type diffusion layer on a certain portion of silicon which is a semiconductor substrate.

### Description of the Related Art

A related art fabrication process of a silicon photovoltaic cell is described hereinbelow.
First, in order to realize high efficiency by promoting optical confinement effects, a p-type silicon substrate having a textured structure formed on a light receiving side is prepared, and subsequently subjected to a treatment at a temperature of 800 to 900°C for several tens of minutes under a mixed gas atmosphere of phosphorus oxychloride (POCl₃), nitrogen and oxygen, thereby uniformly forming an n-type diffusion layer. According to this method of the related art, since diffusion of phosphorus is carried out using a mixed gas, the n-type diffusion layer is formed not only on the surface, but also on the side face and the rear surface. For these reasons, there has been a need for a side etching process to remove the n-type diffusion layer on the side face. Further, the n-type diffusion layer of the rear surface needs to be convened into a p+-type diffusion layer, correspondingly an aluminum paste is assigned to the n-type diffusion layer of the rear surface to achieve conversion of the n-type diffusion layer into the p⁺-type diffusion layer through the diffusion of aluminum.

Meanwhile, in the manufacturing field of semiconductors, a method has been proposed for forming an n-type diffusion layer by applying a solution containing phosphates such as phosphorus pentoxide (P₂O₅) or ammonium dihydrogen phosphate (NH₄H₂PO₄) as a donor element-containing compound (for example, Japanese Patent Application Laid-Open (JP-A) No. 2002-75894). Furthermore, a method is known for forming a diffusion layer by applying, onto a silicone substrate, a paste that becomes a diffusion source and that contains phosphorus as a donor element, and conducting thermal diffusion (for example, Japanese Patent No. 4073968).
However, in such a method, since a donor element or donor element-containing compound vaporizes from a solution or paste, similarly to the above-stated gas-phase reaction method using a mixed gas, diffusion of phosphorus occurs at the side face and rear surface during the formation of a diffusion layer, and an n-type diffusion layer is also formed in an area other than the area to which the paste is applied.

### SUMMARY OF THE INVENTION

A first embodiment according to the present invention is a composition comprising a donor element-containing glass powder and a dispersion medium.
A second embodiment of the present invention is a use of the composition according to any one of the first embodiment for forming an n-type diffusion layer on a semiconductor substrate.
A third embodiment of the present invention is a method for forming an n-type diffusion layer, comprising:
applying the composition of any one of the first embodiment; and
conducting a thermal diffusion treatment.
A fourth embodiment of the present invention is a method for producing a photovoltaic cell, comprising:
applying, on a semiconductor substrate, the composition of any one of the first embodiment; and
subjecting the substrate to a thermal diffusion treatment, thereby forming an n-type diffusion layer.

### BRIEF DESCRIPTION OF THE DRAWINGS

FIG. 1 is a cross-sectional view conceptionally showing an example of the manufacturing process of a photovoltaic cell in the present invention.
FIG. 2A is a plane view of a photovoltaic cell as seen from the front surface.
FIG. 2B is a partially enlarged perspective view of FIG. 2A.

### DETAILED DESCRIPTION OF THE INVENTION

As described above, in a gas-phase reaction using phosphorus oxychloride in the formation of an n-type diffusion layer, an n-type diffusion layer is formed not only on one side that requires the essential n-type diffusion layer (ordinary light-receiving side, front surface), but also on the other face (non-light receiving side, rear surface) or side face. Further, even in a method involving applying a phosphorus-containing solution or paste followed by thermal diffusion, an n-type diffusion layer is also formed on portions even in addition to the front surface, similarly to the gas-phase reaction method. Accordingly, in order to secure a p-n junction structure as an element, a side face should be etched, and a rear surface should be subjected to the conversion of the n-type diffusion layer into the p-type diffusion layer. Generally, the conversion of the n-type diffusion layer into the p-type diffusion layer is achieved by applying, on the rear surface, a paste of aluminum which is an element of Group XIII of the periodic table, followed by sintering. Furthermore, a known method, in which a paste containing donor element such as a phosphorus is applied as a diffusion source, has a drawback in that it is difficult to form a diffusion layer at a selective certain region.

Therefore, the present invention has been made in view of the above problems exhibited by the background art, and it is an object of the present invention to provide a composition, which is capable of forming an n-type diffusion layer on a certain portion of a substrate, without the formation of an unnecessary n-type diffusion layer in a manufacturing process of a photovoltaic cell using a silicon substrate, and furthermore is capable of forming an n⁺ layer or an n⁺⁺ layer on a certain portion of an n-type diffusion layer when a diffusion layer is formed at a certain portion; a use of the composition for forming an n-type diffusion layer on a semiconductor substrate, in the production of a back contact-type photovoltaic cell, and in the manufacture of a solar battery; a method for forming an n-type diffusion layer; and a method for producing a photovoltaic cell.

The invention includes the following embodiments.
<1> A composition comprising a donor element-containing glass powder and a dispersion medium.
<2> The composition according to <1>, wherein the donor element is at least one selected from phosphorous (P) and antimony (Sb).
<3> The composition according to <1> or <2>, wherein the donor element-containing glass powder contains:
   at least one donor element-containing material selected from P₂O₃, P₂O₅ and Sb₂O₃; and
   at least one glass component material selected from SiO₂, K₂O, Na₂O, Li₂O, BaO, SrO, CaO, MgO, BeO, ZnO, PbO, CdO, V₂O₅, SnO, ZrO₂ and MoO₃.
<4> The composition according to any one of <1> to <3>, further comprising a metallic element that crystallizes through reaction with the glass powder.
<5> The composition according to <4>, wherein the metallic element that crystallizes through reaction with the glass powder is at least one selected from silver (Ag), silicon (Si), copper (Cu), iron (Fe), zinc (Zn) or manganese (Mn).
<6> The composition according to any one of <1> to <5>, wherein the composition exhibits paste state.
<7> The composition according to any one of <1> to <6>, wherein the dispersion medium comprises a binder and a solvent.
<8> A use of the composition according to any one of <1> to <7> for forming an n-type diffusion layer on a semiconductor substrate.
<9> A use of the composition according to any one of <1> to <7> in the manufacture of a solar battery.
<10> A method for forming an n-type diffusion layer, comprising:
   applying, on a semiconductor substrate, the composition of any one of <1> to <7>; and
   conducting a thermal diffusion treatment.
<11> A method for producing a photovoltaic cell, comprising:
   applying, on a semiconductor substrate, the composition of any one of <1> to <7>; and
   subjecting the substrate to a thermal diffusion treatment, thereby forming an n-type diffusion layer.
<12> The method for producing a photovoltaic cell according to claim 11, comprising the steps of applying the composition according to any one of <1> to <7> on the textured surface of a silicon substrate, followed by optional drying.
<13> The method for producing a photovoltaic cell according to <12>, wherein the silicon substrate having a textured surface structure is formed by removing the damaged surface layer from a silicon substrate sliced from an ingot and etching the thus obtained silicon substrate to form a textured surface structure.
<14> The method for producing a photovoltaic cell according to <12> or <13>, which comprises subsequent to applying the composition on the textured surface and optional drying the following steps:
   (i) thermal diffusion treatment, preferably at a temperature of 600 to 1200 °C, to form a glass layer and an n-type diffusion layer beneath the glass layer;
   (ii) removing the glass layer by etching;
   (iii) forming a p⁺-type diffusion layer on the rear surface of the substrate;
   (iv) forming an antireflective film over the n-type diffusion layer;
   (v) forming surface electrode on the antireflective film;
   (vi) forming rear surface electrode on the p⁺-type diffusion layer; and
   (vii) sintering to establish electrical connection between the surface electrode and the silicon substrate.
<15> A use of the composition according to any one of <1> to <7> in the production of a back contact-type photovoltaic cell.
<16> A method for forming an n-type diffusion region in a semiconductor, comprising the steps of:
   1) coating a portion of a semiconductor substrate with a layer of a composition comprising a dispersion of donor element-containing glass particles in a dispersion medium; and
   2) heating the coated semiconductor substrate to a temperature sufficient to cause donor element diffusion from the glass into the semiconductor substrate so as to form an n-type diffusion region in the semiconductor substrate.

The present invention enables the formation of an n-type diffusion layer on a certain portion of a substrate, without the formation of an n-type diffusion layer at an undesirable portion in the manufacturing process of a photovoltaic cell using a silicon substrate. Furthermore, the present invention relates to the use of the composition in the production of a back contact-type photovoltaic cell and in the manufacture of a solar battery.
The suitability of the composition according to the present invention for forming an n-type diffusion layer is also reflected in this specification by referring to the composition as a "composition for forming an n-type diffusion layer".

First, a composition for forming an n-type diffusion layer in accordance with the present invention will be described, and then a method for forming an n-type diffusion layer and a method for producing a photovoltaic cell, using the composition for forming an n-type diffusion layer, will be described.
In the present specification, the term "process" denotes not only independent processes but also processes that cannot be clearly distinguished from other processes as long as a purpose is accomplished by the process.
In the present specification, "from...to..." denotes a range including each of the minimum value and the maximum value of the values described in this expression.

The composition for forming an n-type diffusion layer in accordance with the present invention contains at least a donor element-containing glass powder (hereinafter, often referred to simply as "glass powder") and a dispersion medium, and may further contain other additives as necessary, taking into consideration coatability or the like.
As used herein, the term "composition for forming an n-type diffusion layer" refers to a material which contains a donor element-containing glass powder and is capable of forming an n-type diffusion layer through thermal diffusion of the donor element after application of the material to a silicon substrate. The use of the composition including the donor element-containing glass powder for forming an n-type diffusion layer in accordance with the present invention ensures that an n-type diffusion layer is formed in a desired portion, and an unnecessary n-type diffusion layer is not formed on a rear surface or side face.

Accordingly, when the composition for forming an n-type diffusion layer according to the present invention is applied, a side etching process essential in the conventionally widely used gas-phase reaction method becomes unnecessary; consequently the process is simplified. In addition, a process for converting an n-type diffusion layer formed on the rear surface into a p⁺-type diffusion layer becomes unnecessary. For these reasons, a method of forming a p⁺-type diffusion layer on the rear surface and the constituent material, shape and thickness of a rear surface electrode are not limited, and the range of applicable producing methods, constituent materials and shapes is widened. Although details will be described hereinafter, the occurrence of internal stress in a silicon substrate due to the thickness of the rear surface electrode is suppressed; consequently warpage of the silicon substrate is also suppressed.

Further, a glass powder contained in the composition for forming an n-type diffusion layer in accordance with the present invention is melted by means of sintering to form a glass layer over an n-type diffusion layer. However, a conventional gas-phase reaction method or a conventional method of applying a phosphate-containing solution or paste also forms a glass layer over an n-type diffusion layer, and therefore the glass layer formed in the present invention can be removed by etching, similarly to the conventional method. Accordingly, even when compared with the conventional method, the composition for forming an n-type diffusion layer in accordance with the present invention generates no unnecessary products and no further additional processes.

Further, since a donor component in the glass powder is hardly volatilized even during sintering, an n-type diffusion layer is prevented from also being formed on the rear surface or side face, rather than on the front surface alone due to the generation of volatile gases. It is assumed that the reason for this is that the donor component combines with an element in a glass powder, or is absorbed into the glass, as a result of which the donor component is hardly volatilized.

As described above, since the composition for forming an n-type diffusion layer in accordance with the present invention can form an n-type diffusion layer in a desired portion at a desired concentration, it is possible to form a selective region with a high n-type dopant concentration.
Meanwhile, it is difficult to form a selective region having a high n-type dopant concentration by a conventional method such as a method using a gas-phase reaction or a method using a solution containing phosphates.

The donor element-containing glass powder in accordance with the present invention will be described in more detail.
As used herein, the term "donor element" refers to an element which is capable of forming an n-type diffusion layer by doping thereof on a silicon substrate. As the donor element, elements of Group XV of the periodic table can be used. Examples of the donor element include P (phosphorous), Sb (antimony), Bi (bismuth) and As (arsenic). From the viewpoint of safety, convenience of vitrification or the like, P or Sb is preferable.

Examples of the donor element-containing material which is used for introducing the donor element into the donor element-containing glass powder include P₂O₃, P₂O₅, Sb₂O₃, Bi₂O₃, and As₂O₃. At least one selected from P₂O₃, P₂O₅ and Sb₂O₃ is preferably used.

Further, the melting temperature, softening point, glass-transition point, chemical durability or the like of the glass powder can be controlled by adjusting the component ratio, if necessary. Further, the glass powder preferably contains the glass component material mentioned below.
Examples of the glass component material include SiO₂, K₂O, Na₂O, Li₂O, BaO, SrO, CaO, MgO, BeO, ZnO, PbO, CdO, V₂O₅, SnO, ZrO₂, WO₃, MoO₃, MnO, La₂O₃, Nb₂O₅, Ta₂O₅, Y₂O₃, TiO₂, ZrO₂, GeO₂, TeO₂, and Lu₂O₃. At least one selected from SiO₂, K₂O, Na₂O, Li₂O, BaO, SrO, CaO, MgO, BeO, ZnO, PbO, CdO, V₂O₅, SnO, ZrO₂, and MoO₃ is preferably used. At least one selected from SiO₂, K₂O, Na₂O, Li₂O, BaO, SrO, CaO, MgO, BeO, ZnO, PbO, CdO, V₂O₅, SnO, ZrO₂, and MoO₃ is more preferably used.

Specific examples of the donor element-containing glass powder include materials including both the donor element-containing material and the glass component material, for example, P₂O₅ based glass which includes P₂O₅ as the donor element such as P₂O₅-SiO₂ (the donor element-containing material and the glass component material are listed in this order, and are listed in the same order below)-based glass, P₂O₅-K₂O-based glass, P₂O₅-Na₂O-based glass, P₂O₅-Li₂O-based glass, P₂O₅-BaO-based glass, P₂O₅-SrO-based glass, P₂O₅-CaO-based glass, P₂O₅-MgO-based glass, P₂O₅-BeO-based glass, P₂O₅-ZnO-based glass, P₂O₅-CdO-based glass, P₂O₅-PbO-based glass, P₂O₅-V₂O₅-based glass, P₂O₅-SnO-based glass, P₂O₅-GeO₂-based glass, and P₂O₅-TeO₂-based glass; Sb₂O₃ based glass in which P₂O₅ is replaced by Sb₂O₃ as a donor element in the P₂O₅ based glass.
The donor element-containing glass powder may include two or more donor element-containing materials such as P₂O₅-Sb₂O₃, P₂O₅-As₂O₃ or the like.
Although composite glass containing two components was illustrated in the above, composite glass containing three or more components, such as P₂O₅-SiO₂-V₂O₅ or P₂O₅-SiO₂-CaO, may also be possible.

The content of the glass component material in the glass powder is preferably appropriately set taking into consideration the melting temperature, the softening point, the glass-transition point, and chemical durability. Generally, the content of the glass component material is preferably from 0.1% by mass to 95% by mass, and more preferably from 0.5% by mass to 90% by mass.

Specifically, for example, glass containing at least one selected from SiO₂, K₂O, Na₂O, Li₂O, BaO, SrO, CaO, MgO, BeO, ZnO, PbO, CdO, SnO, ZrO₂, WO₃, MoO₃ and MnQ, as the glass component material) is preferable, from a viewpoint that a reaction product with silicon does not remaine as a residue when treated with hydrofluoric acid, therefore these glasses are preferable.
Meanwhile, when the donor element-containing glass powder is P₂O₅-V₂O₅-based glass, the content of V₂O₅ is preferably from 1% by mass to 50% by mass, and more preferably from 3% by mass to 40% by mass, from the viewpoint of lowering a melting temperature or a softening point.

The softening point of the glass powder is preferably in the range of from 200°C to 1000°C, and more preferably from 300°C to 900°C, from the viewpoint of diffusivity during the diffusion treatment, and dripping.

The shape of the glass powder includes a substantially spherical shape, a flat shape, a block shape, a plate shape, a scale-like shape, and the like. From the viewpoint of the coating property and uniform dispersion property, it is preferably a spherical shape, a flat shape, or a plate shape.
The particle diameter of the glass powder is preferably 100 µm or less. When a glass powder having a particle diameter of 100 µm or less is used, a smooth coated film can be easily obtained. Further, the particle diameter of the glass powder is more preferably 50 µm or less. The lower limit of the particle diameter is not particularly limited, and preferably 0.01 µm or more.
The particle diameter of the glass powder means the average particle diameter, and may be measured by laser diffraction particle size analyzer.

The donor element-containing glass powder is prepared according to the following procedure.
First, raw materials, for example, the donor element-containing material and the glass component material, are weighed and placed in a crucible. Examples of the material for the crucible include platinum, platinum-rhodium, iridium, alumina, quartz and carbon, which are appropriately selected taking into consideration the melting temperature, atmosphere, reactivity with melted materials, and the like.
Next, the raw materials are heated to a temperature corresponding to the glass composition in an electric furnace, thereby preparing a solution. At this time, stirring is preferably applied such that the solution becomes homogenous.
Subsequently, the obtained solution is allowed to flow on a zirconia substrate, a carbon substrate or the like to result in vitrification of the solution.
Finally, the glass is pulverized into a powder. The pulverization can be carried out by using a known method such as using a jet mill, bead mill or ball mill.

The content of the donor element-containing glass powder in the composition for forming an n-type diffusion layer is determined taking into consideration coatability, diffusivity of donor elements, and the like. Generally, the content of the glass powder in the composition for forming an n-type diffusion layer is preferably from 0.1% by mass to 95% by mass, more preferably from 1% by mass to 90% by mass, still more preferably from 1.5% by mass to 85% by mass, and furthermore preferably from 2% by mass to 80% by mass.

Hereinafter, a dispersion medium will be described.
The dispersion medium is a medium which disperses the glass powder in the composition. Specifically, a binder, a solvent or the like is employed as the dispersion medium.

For example, the binder may be appropriately selected from a polyvinyl alcohol, polyacrylamides, polyvinyl amides, polyvinyl pyrrolidone, polyethylene oxides, polysulfonic acid, acrylamide alkyl sulfonic acid, cellulose derivatives such as cellulose ethers, carboxymethylcellulose, hydroxyethylcellulose and ethylcellulose, gelatin, starch and starch derivatives, sodium alginates, xanthane, guar and guar derivatives, scleroglucan and scleroglucan derivatives, tragacanth and tragacanth derivatives, dextrin and dextrin derivatives, (meth)acrylic acid resins, (meth)acrylic acid ester resins (for example, alkyl (meth)acrylate, resins, dimethlaminoethyl (meth)acrylate resins, or the like), butadiene resins, styrene resins, and copolymers thereof, siloxane resins, and the like. These compounds may be used individually or in a combination of two or more thereof.

The molecular weight of the binder is not particularly limited and is preferably appropriately adjusted taking into consideration the desired viscosity of the composition.

Examples of the solvent include ketone solvents such as acetone, methylethylketone, methyl-n-propylketone, methyl-iso-propylketone, methyl-n-butylketone, methyl-iso-butylketone, methyl-n-pentylketone, methyl-n-hexylketone, diethylketone, dipropylketone, di-iso-butylketone, trimethylnonanone, cyclohexanone, cyclopentanone, methylcyclohexanone, 2,4-pentanedione, acetonylacetone, γ-butyrolactone, and γ-valerolactone; ether solvents such as diethyl ether, methyl ethyl ether, methyl-n-propyl ether, di-iso-propyl ether, tetrahydrofuran, methyl tetrahydrofuran, dioxane, dimethyl dioxane, methylene glycol dimethyl ether, ethylene glycol diethyl ether, ethylene glycol di-n-propyl ether, ethylene glycol dibutyl ether, diethylene glycol dimethyl ether, diethylene glycol diethyl ether, diethylene glycol methyl ethyl ether, diethylene glycol methyl mono-n-propyl ether, diethylene glycol methyl mono-n-butyl ether, diethylene glycol di-n-propyl ether, diethylene glycol di-n-butyl ether, diethylene glycol methyl mono-n-hexyl ether, triethylene glycol dimethyl ether, triethylene glycol diethyl ether, triethylene glycol methyl ethyl ether, triethylene glycol methyl mono-n-butyl ether, triethylene glycol di-n-butyl ether, triethylene glycol methyl mono-n-hexyl ether, tetraethylene glycol dimethyl ether, tetraethylene glycol diethyl ether, tetradiethylene glycol methyl ethyl ether, tetraethylene glycol methyl mono-n-butyl ether, diethylene glycol di-n-butyl ether, tetraethylene glycol methyl mono-n-hexyl ether, tetraethylene glycol di-n-butyl ether, propylene glycol dimethyl ether, propylene glycol diethyl ether, propylene glycol di-n-propyl ether, propylene glycol dibutyl ether, dipropylene glycol dimethyl ether, dipropylene glycol diethyl ether, dipropylene glycol methyl ethyl ether, dipropylene glycol methyl mono-n-butyl ether, dipropylene glycol di-n-propyl ether, dipropylene glycol di-n-butyl ether, dipropylene glycol methyl mono-n-hexyl ether, tripropylene glycol dimethyl ether, tripropylene glycol dimethyl esther, tripropylene glycol methyl ethyl ether, tripropylene glycol methyl mono-n-butyl ether, tripropylene glycol di-n-butyl ether, tripropylene glycol methyl mono-n-hexyl ether, tetrapropylene glycol dimethyl ether, tetrapropylene glycol dimethyl ether, tetradipropylene glycol methyl ethyl ether, tetrapropylene glycol methyl mono-n-butyl ether, dipropylene glycol di-n-butyl ether, tetrapropylene glycol methyl mono-n-hexyl ether, and tetrapropylene glycol di-n-butyl ether; ester solvents such as methyl acetate, ethyl acetate, n-propyl acetate, i-propyl acetate, n-butyl acetate, i-butyl acetate, see-butyl acetate, n-pentyl acetate, sec-pentyl acetate, 3-methoxybutyl acetate, methyl pentyl acetate, 2-ethyl butyl acetate, 2-ethyl hexyl acetate, 2-(2-butoxyethoxy)ethyl acetate, benzyl acetate, cyclohexyl acetate, methyl cyclohexyl acetate, nonyl acetate, methyl acetoacetate, ethyl acetoacetate, diethylene glycol monomethyl ether acetate, diethylene glycol monoethyl ether acetate, diethylene glycol mono-n-butyl ether acetate, dipropylene glycol monomethyl ether acetate, dipropylene glycol monoethyl ether acetate, glycol diacetate, methoxy triglycol acetate, ethyl propionate, n-butyl propionate, 1-amyl propionate, diethyl oxalate, di-n-butyl oxalate, methyl lactate, ethyl lactate, n-butyl lactate, and n-amyl lactate; ether acetate solvents such as ethylene glycol methyl ether propionate, ethylene glycol ethyl ether propionate, ethylene glycol methyl ether acetate, ethylene glycol ethyl ether acetate, diethylene glycol methyl ether acetate, diethylene glycol ethyl ether acetate, diethylene glycol-n-butyl ether acetate, propylene glycol methyl ether acetate, propylene glycol ethyl ether acetate, propylene glycol propyl ether acetate, dipropylene glycol methyl ether acetate, and dipropylene glycol ethyl ether acetate; aprotic polar solvents such as acetonitrile, N-methyl pyrrolidinone, N-ethyl pyrrolidinone, N-propyl pyrrolidinone, N-butyl pyrrolidinone, N-hexyl pyrrolidinone, N-cyclohexyl pyrrolidinone, N,N-dimethyl formamide, N,N-dimethyl acetamide, and dimethyl sulfoxide; alcohol solvents such as methanol, ethanol, n-propanol, i-propanol, n-butanol, i-butanol, sec-butanol, t-butanol, n-pentanol, i-pentanol, 2-methylbutanol, sec-pentanol, t-pentanol, 3-methoxy butanol, n-hexanol, 2-methylpentanol, sec-hexanol, 2-ethylbutanol, sec-heptanol, n-octanol, 2-ethylhexanol, sec-octanol, n-nonyl alcohol, n-decanol, sec-undecyl alcohol, trimethylnonyl alcohol, sec-tetradecyl alcohol, sec-heptadecyl alcohol, phenol, cyclohexanol, methylcyclohexanol, benzyl alcohol, ethylene glycol, 1,2-propylene glycol, 1,3-butylene glycol, diethylene glycol, dipropylene glycol, triethylene glycol, and tripropylene glycol; glycol monoether solvents such as ethylene glycol methyl ether, ethylene glycol ethyl ether, ethylene glycol monophenyl ether, diethylene glycol monomethyl ether, diethylene glycol monoethyl ether, diethylene glycol mono-n-butyl ether, diethylene glycol mono-n-hexyl ether, ethoxy triglycol, tetraethylene glycol mono-n-butyl ether, propylene glycol monomethyl ether, dipropylene glycol monomethyl ether, dipropylene glycol monoethyl ether, and tripropylene glycol monomethyl ether; terpene solvents such as α- terpinene, α- terpinenol, myrcene, allo-ocimene, imonene, dipentene,a-dipentene, β-dipentene, terpinenol, carvone, ocimene and phellandrene; water, and the like. These materials may be used individually or in a combination of two or more thereof. From the viewpoint of the coating property of the composition for forming an n-type diffusion layer at a substrate, a-terpinenol, diethylene glycol mono-n-butyl ether or diethylene glycol mono-n-butyl ether acetate is preferable, and a-terpinenol or diethylene glycol mono-n-butyl ether is more preferable.

The content of the dispersion medium in the composition for forming an n-type diffusion layer is determined taking into consideration coatability and donor concentration.

Further, the composition for forming an n-type diffusion layer may contain other additives. Examples of the other additives include metals which are readily reactive with the glass powder.
The composition for forming an n-type diffusion layer is applied on a semiconductor substrate and heat-treated at a high temperature to form an n-type diffusion layer, during which glass is formed on the surface of the substrate. This glass is removed by dipping in acid such as hydrofluoric acid, but may be difficult to remove depending on the type of glass. In such a case, by adding a metal, such as Ag, Mn, Cu, Fe, Zn or Si, the glass can be easily removed after acid washing. Among them, at least one selected from Ag, Si, Cu, Fe, Zn and Mn is preferably used. At least one selected from Ag, Si and Zn is more preferably used, and Ag is still more preferably used.

The content of the metal is preferably appropriately adjusted depending on the type of glass or the type of the metal concerned. Generally, the content of the metal is preferably from 0.01% by mass to 10% by mass, relative to the glass powder.

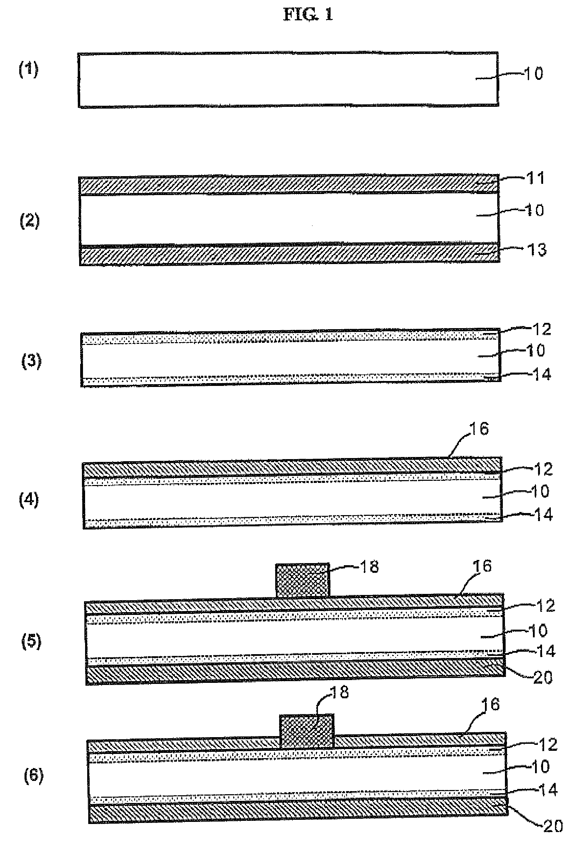

Hereinafter, the method for forming an n-type diffusion layer and the method for producing a photovoltaic cell according to the present invention are described with reference to FIG. 1. FIG, 1 is a schematic cross-sectional view conceptionally showing an example of the production process of a photovoltaic cell according to the present invention. In the drawings, like numbers refer to like elements throughout the specification.

In PIG. 1(1), an alkaline solution is assigned to silicon substrate which is a p-type semiconductor substrate 10, thereby removing the damaged layer, and a textured structure is obtained by etching.
Specifically, the damaged layer of the silicon surface, which is caused when being sliced from an ingot, is removed by using 20% by mass of caustic soda. Then, a textured structure is formed by etching with a mixture of 1% by mass of caustic soda and 10% by mass of isopropyl alcohol (in the drawing, the textured structure is omitted). The photovoltaic cell achieves high efficiency through the formation of a textured structure on the light-receiving side (front surface) to promote optical confinement effects.

In FIG. 1(2), the composition for forming an n-type diffusion layer is applied on the surface of the p-type semiconductor substrate 10, that is, a face serving as a light-receiving side, thereby forming an n-type diffusion layer-forming composition layer 11. In the present invention, there is no limit to the application method, for example, a printing method, a spinning method, brush application, a spray method, a doctor blade method, a roll coater method, an inkjet method or the like can be used.
The amount of coating of the composition for forming an n-type diffusion layer is not particularly limited, but is in the range of from 0.01 to 100 g/m² in terms of glass powder, and preferably from 0.1 to 10 g/m².

Further, depending on the composition of the composition for forming an n-type diffusion layer, a drying process for volatilization of the solvent contained in the composition may be required after the application thereof, if necessary. In this case, the drying is carried out at a temperature of 80°C to 300°C, for 1 minute to 10 minutes when using a hot plate, or for 10 minutes to 30 minutes when using a dryer or the like. Since these drying conditions are dependent on the solvent composition of the composition for forming an n-type diffusion layer, the present invention is not particularly limited to the above-stated conditions.

When using the producing method of the present invention, a producing method of a p⁺-type diffusion layer (high-density electric field layer) 14 of the rear surface can employ any conventional known method without being limited to the method involving conversion of an n-type diffusion layer into a p-type diffusion layer using aluminum, and the range of choices for the producing method is then widened. Accordingly, for example, by assigning the composition 13 containing an element of Group XIII of the periodic table, such as boron (B), the high-density electric field layer 14 can be formed.
As the composition 13 containing an element of Group XIII of the periodic table, such as boron (B), a composition for forming an p-type diffusion layer is included.
The composition for forming a p-type diffusion layer is composed in the same manner as the composition for forming an n-type diffusion layer, except that the glass powder contains an acceptor element, which may be an element of Group XIII of the periodic table, for example, boron (B), aluminium (Al) or gallium (Ga) or the like, instead of the donor element. The acceptor element-containing glass powder preferably includes at least one selected from B₂O₃, Al₂O₃ and Ga₂O₃. The method for applying the composition for forming a p-type diffusion layer to a rear side of a silicon substrate is the same as the method mentioned above for applying the composition for forming an n-type diffusion layer to a silicon substrate.
The composition for forming a p-type diffusion applied to the rear side is subjected to thermal diffusion treatment in the same manner as when the composition for forming an n-type diffusion layer is used, thereby forming the high-density electric field layer 14 on the rear side. The thermal diffusion treatment of the composition for forming a p-type diffusion layer is preferably simultaneously conducted with the thermal diffusion treatment of the composition for forming an n-type diffusion layer.

Next, the semiconductor substrate 10, on which the n-type diffusion layer-forming composition layer 11 was formed, is subjected to a thermal diffusion treatment at a temperature of 600 to 1200°C. This thermal diffusion treatment results in diffusion of a donor element into the semiconductor substrate, thereby forming an n-type diffusion layer 12, as shown in FIG. 1(3). The thermal diffusion treatment can be carried out using a known continuous furnace, batch furnace, or the like. In addition, when performing the thermal diffusion treatment, the furnace atmosphere can be appropriately adjusted with air, oxygen, nitrogen, or the like.
The treatment time of the thermal diffusion can be appropriately selected depending on the content of a donor element contained in the composition for forming an n-type diffusion layer. For example, the treatment time of the thermal diffusion may be in the range of from 1 minute to 60 minutes, and preferably from 2 minutes to 30 minutes.

Since a glass layer (not shown) made of phosphoric acid glass or the like is formed on the surface of the formed n-type diffusion layer 12, the phosphoric acid glass is removed by etching. The etching can be carried out by using a known method, including a method of dipping a subject in an acid, such as hydrofluoric acid, a method of dipping a subject in an alkali, such as caustic soda, or the like.

As shown in FIGS. 1(2) and 1(3), the n-type diffusion layer-forming method of the present invention for forming an n-type diffusion layer 12 using the composition for forming an n-type diffusion layer 11 according to the present invention provides the formation of an n-type diffusion layer 12 in the desired site, without the formation of an unnecessary n-type diffusion layer on the rear surface or side face.
Accordingly, a side etching process for the removal of an unnecessary n-type diffusion layer formed on the side face was essential in a method for forming an n-type diffusion layer by the conventionally widely used gas-phase reaction method, but according to the producing method of the present invention, the side etching process becomes unnecessary, and consequently the process is simplified.

Further, the conventional producing method requires the conversion of an unnecessary n-type diffusion layer formed on the rear surface into a p-type diffusion layer, and this conversion method employs a method involving applying a paste of aluminum, which is an element of Group XIII of the periodic table, on the n-type diffusion layer of the rear surface, followed by sintering to diffuse aluminum into the n-type diffusion layer which is thereby converted into a p-type diffusion layer. Since an amount of aluminum greater than a certain level is required to achieve sufficient conversion into a p-type diffusion layer and to form the high-density electric field layer of the p⁺ layer in this method, it was necessary to form a thick aluminum layer. However, since the coefficient of the thermal expansion of aluminum is considerably different from the coefficient of the thermal expansion of the silicon which is used as a substrate, such a difference results in generation of heavy internal stress in the silicon substrate during the sintering and cooling processes, which contributes to warpage of the silicon substrate.
Such internal stress damages the grain boundary of crystals, resulting in the problem of an increase in power loss, Further, warpage readily leads to damage of cells in the conveyance of photovoltaic cells or in the connection with a copper line referred to as a tab line, during a module process. In recent years, advancement in slice processing techniques has led to thickness reduction of a silicon substrate, which results in a tendency for the cell to be more readily cracked.

However, since, according to the producing method of the present invention, no unnecessary n-type diffusion layer is formed on the rear surface, there is no need for the conversion of an n-type diffusion layer into a p-type diffusion layer, which consequently abolishes the necessity of making the aluminum layer thicker. As a result, it is possible to suppress the generation of internal stress in the silicon substrate or warpage. Accordingly, an increase in power loss, or damage to cells can be suppressed.

Further, when using the fabrication method of the present invention, the producing method of a p⁺-type diffusion layer (high-density electric field layer) 14 of the rear surface can employ any method without being limited to the method involving conversion of an n-type diffusion layer into a p-type diffusion layer using aluminum, and choices for the producing method are then broadened.
For example, it is preferable that the composition for forming a p-type diffusion layer is composed in the same manner as the composition for forming an n-type diffusion layer, except that the glass powder contains an acceptor element instead of the donor element; the composition for forming a p-type diffusion layer is applied to a rear side of a silicon substrate (i.e., the opposite surface to the surface to which the composition for forming an n-type diffusion layer is applied); and thermal diffusion treatment is carried out; thereby forming the high-density electric field layer 14 on the rear side.
As will be described later, the material used for a surface electrode 20 of the rear surface is not limited to aluminum of Group XIII of the periodic table. For example Ag (silver), Cu (copper) or the like may also be used, so the thickness of the surface electrode 20 of the rear surface can be further reduced as compared to the related art.

In FIG. 1(4), an antireflective film 16 is formed over the n-type diffusion layer 12. The antireflective film 16 is formed by using a known technique. For example, when the antireflective film 16 is a silicon nitride film, the antireflective film 16 is formed by a plasma CVD method using a mixed gas of SiH₄ and NH₃ as a raw material. At this time, hydrogen diffuses into crystals, and an orbit which does not contribute to bonding of silicon atoms, that is, a dangling bond binds to hydrogen, which inactivates a defect (hydrogen passivation).
More specifically, the antireflective film 16 is formed under the conditions of a mixed gas NH₃/SiH₄ flow ratio of 0.05 to 1.0, a reaction chamber pressure of 0.1 Torr to 2 Torr, a film-forming temperature of 300°C to 550°C. and a plasma discharge frequency of 100 kHz or higher.

In FIG. 1(5), a metal paste for a surface electrode is printed and applied on the antireflective film 16 of the front surface (light-receiving side) by a screen printing method, followed by drying to form a surface electrode 18. The metal paste for a surface electrode contains (1) metal particles and (2) glass particles as essential components, and optionally (3) a resin binder, (4) other additives, and the like.

Then, a rear surface electrode 20 is also formed on the high-density electric field layer 14 of the rear surface. As described hereinbefore, the constituent maternal and forming method of the rear surface electrode 20 are not particularly limited in the present invention. For example, the rear surface electrode 20 may also be formed by applying the rear surface electrode paste containing a metal such as aluminum, silver or copper, followed by drying. In this case, a portion of the rear surface may also be provided with a silver paste for forming a silver electrode, for connection between cells in the module process.

In FIG. 1(6), electrodes are sintered to complete a photovoltaic cell, When the sintering is carried out at a temperature in the range of 600 to 900°C for several seconds to several minutes, the front surface side undergoes melting of the antireflective film 16 which is an insulating film, due to the glass particle contained in the electrode-forming metal paste, and the silicon 10 surface is also partially melted, by which metal particles (for example, silver particles) in the paste form a contact with the silicon substrate 10, followed by solidification. In this manner, electrical conduction is made between the formed surface electrode 18 and the silicon substrate 10. This process is called fire-through.

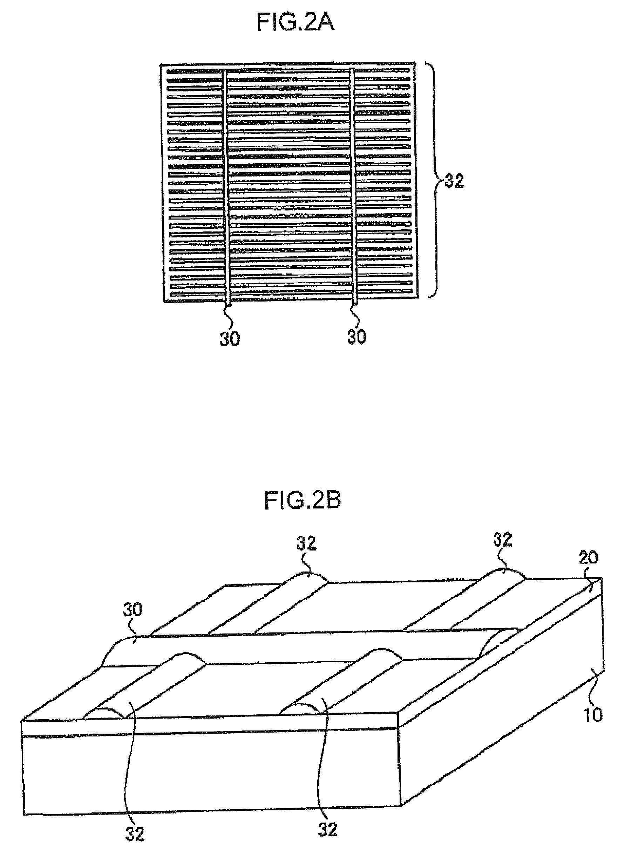

Hereinafter, the shape of the surface electrode 18 is described. The surface electrode 18 is made up of a bus bar electrode 30 and a finger electrode 32 intersecting the bus bar electrode 30. FIG 2A is a plan view of, as seen from the front surface, a photovoltaic cell with a configuration where the surface electrode 18 is made up of the bus bar electrode 30 and the finger electrode 32 intersecting the bus bar electrode 30, and FIG. 2B is a partially enlarged perspective view of FIG. 2A.

The surface electrode 18 can be formed, for example, by the above-stated screen printing of a metal paste, or plating of electrode materials, deposition of electrode materials by electron beam heating under high vacuum, or the like. It is well known that the surface electrode 18 made up of the bus bar electrode 30 and the finger electrode 32 is typically used as an electrode for the light-receiving surface side, and a known method for the formation of the bus bar electrode and the finger electrode of the light-receiving surface side can be applied.

Although a photovoltaic cell having an n-type diffusion layer formed on the front surface, a p⁺-type diffusion layer formed on the rear surface, and a front surface electrode and a rear surface electrode disposed on the respective layers was described above, the use of the composition for forming an n-type diffusion layer according to the present invention enables the production of a back-contact photovoltaic cell.
The back-contact photovoltaic cell is intended to enlarge a light-receiving surface by providing all of the electrodes on the rear surface, That is, the back-contact photovoltaic cell is required to have a p-n junction structure by forming both an n-type diffusion region and a p⁺type diffusion region on the rear surface. The composition for forming an n-type diffusion layer according to the present invention enables the formation of an n-type diffusion portion on a certain region, and therefore can be preferably applied to the production of a back-contact photovoltaic cell,

### EXAMPLES

Hereinafter, Examples in accordance with the present invention will be described in more detail, but the present invention is not limited thereto. Unless specifically indicated, the chemicals used were all of reagent-grade. Unless specifically indicated, "%" refers to "% by mass".

### [Example 1]

20 g of P₂O₅-V₂O₅-based glass powder whose particle shape is substantially spherical, average particle diameter is 3.5 µm and softening point is 554 °C (P₂O₅: 29.6%, V₂O₅: 10%, BaO: 10.4%, MoO₃: 10%, WO₃:30%, K₂O: 10%),0.3 g of ethylcellulose and 7 g of 2-(2-butoxyethoxy)ethyl acetate were mixed with an automatic mortar kneading machine and made into a paste to prepare a composition for forming an n-type diffusion layer.
The particle shape of the glass powder was judged by observation with a scanning electron microscope (trade name: TM-1000, manufactured by Hitachi High-Technologies Corporation). The average diameter of the glass powder was calculated with a laser diffraction particle size analyzer (measurement wave length: 632 nm, trade name: LS 13 320, manufactured by Beckman Coulter, Inc.). The softening point of the glass powder was measured by a differential thermal analysis (DTA) curve with a Thermo Gravimetry Differential Thermal Analyzer (trade name: DTG-60H, manufactured by SHMADZU CORPORATION).
Next, the prepared paste was applied to a p-type silicon substrate surface by screen printing, and dried on a hot plate at 150°C for 5 minutes to form a layer having about 18µm thickness. Subsequently, a thermal diffusion treatment was carried out in an electric furnace at 1000°C for 10 minutes. Then, in order to remove the glass layer, the substrate was dipped in hydrofluoric acid for 5 minutes, followed by washing with running water. Some attached materials remained on the surface, but could be easily removed by rubbing with a cloth. This was followed by drying.

The surface at the side to which the composition for forming an n-type diffusion layer was applied exhibited a sheet resistance of 186 Ω/□ and an n-type diffusion layer was formed through diffusion of P (phosphorus) that can sufficiently function as a photovoltaic cell. On the other hand, the rear surface exhibited an unmeasurable sheet resistance of 1,000,000 Ω/□ or higher and substantially no n-type diffusion layer was formed.
The sheet resistance was measured by a four probe method with a low resistance meter (trade name: Loresta-EP MCP-T360, manufactured by Mitsubishi Chemical Analytech Co., Ltd.).

### [Example 2]

An n-type diffusion layer was formed in the same manner as in Example 1, except that the thermal diffusion treatment time was 20 minutes. The surface at the side, where the composition for forming an n-type diffusion layer was applied exhibited a sheet resistance of 70 Ω/□ and the formation of an n-type diffusion layer through diffusion of P (phosphorus).
On the other hand, the rear surface exhibited an unmeasurable sheet resistance of 1,000,000 Ω/□ or higher and substantially no formation of an n-type diffusion layer.

### [Example 3]

An n-type diffusion layer was formed in the same manner as in Example 1, except that the thermal diffusion treatment time was 30 minutes. The surface at the side where the composition for forming an n-type diffusion layer was applied exhibited a sheet resistance of 17 Ω/□ and the formation of an n-type diffusion layer through diffusion of P (phosphorus).
On the other hand, the rear surface exhibited an unmeasurable sheet resistance of 1,000,000 Ω/□ or higher and substantively no formation, of an n-type diffusion layer.

### [Example 4]

An n-type diffusion layer was formed in the same manner as in Example 1. except that the glass powder was changed to P₂O₅-SnO-based glass whose particle shape is substantially spherical, average particle diameter is 3.2 µm and softening point is 493°C (P₂O₅: 70%, SnO: 20%, SiO₂: 5%, CaO: 5%) and the furnace atmosphere when performing the thermal diffusion was nitrogen. The surface at the side where the composition for forming an n-type diffusion layer was applied exhibited a sheet resistance of 77 Ω/□ and the formation of an n-type diffusion layer through diffusion of P (phosphorus).
On the other hand, the rear surface exhibited an unmeasurable sheet resistance of 1,000,000 Ω/□ or higher and substantively no formation of an n-type diffusion layer.

### [Example 5]

An n-type diffusion layer was formed in the same manner as in Example 1, except that the glass powder was changed to P₂O₅-ZnO-SiO₂-based glass powder whose particle shape is substantially spherical, average particle diameter is 2.5 µm and softening point is 460°C (P₂OS: 60%, ZnO: 30%, SiO₂: 10%). The surface at the side where the composition for forming an n-type diffusion layer was applied exhibited a sheet resistance of 10 Ω/□ and the formation of an n-type diffusion layer through diffusion of P (phosphorus).
On the other hand, the rear surface exhibited an unmeasurable sheet resistance of 1,000,000 Ω/□ or higher and substantively no formation of an n-type diffusion layer.

### [Example 6]

19.7 g of P₂O₅-V₂O₅-based glass of Example 1 (P₂O₅ 29.6%, V₂O₅: 10%, BaO: 10.4%, MoO₃: 10%, WO₃: 30%, K₂O: 10%) powder, 0.3 g of Ag, 0.3 g of ethylcellulose and 7 g of 2-(2-butoxyethoxy)ethyl acetate were mixed with an automatic mortar kneading machine and made into a paste to prepare a composition for forming an n-type diffusion layer. Since then, the procedure was carried out in the same manner as in Examples 2.
As a result, the post-washing substrate exhibited no glass material attached thereto, thus exemplifying that the attached material was easily removed. The surface exhibited a sheet resistance of 70 Ω/□ as in Example 2, and the rear surface exhibited substantively no formation of an n-type diffusion layer.

### [Example 7]

An n-type diffusion layer was formed in the same manner as in Example 1, except that the glass powder was changed to P₂O₅-ZnO-based glass powder whose particle shape is substantially spherical, average particle diameter is 1.3 µm and softening point is 435°C (P₂O₅: 65%, ZnO: 35%).
The surface at the side where the composition for forming an n-type diffusion layer was applied exhibited a sheet resistance of 18 Ω/□ and the formation of an n-type diffusion layer through diffusion of P. On the other hand, the rear surface exhibited an unmeasurable sheet resistance and no formation of an n-type diffusion, layer.

### [Example 8]

An n-type diffusion layer was formed in the same manner as in Example 1, except that the glass powder was changed to P₂O₅-ZnO-Al₂O₃-based glass powder whose particle shape is substantially spherical, average particle diameter is 2.9 µm and softening point is 423°C (P₂O₅: 61%, ZnO: 35%, Al₂:4%).
The surface at the side where the composition for forming an n-type diffusion layer was applied exhibited a sheet resistance of 21 Ω/□ and the formation of an n-type diffusion layer through diffusion of P. On the other hand, the rear surface exhibited an unmeasurable sheet resistance and substantively no formation of an n-type diffusion layer.

### [Example 9]

An n-type diffusion layer was formed in the same manner as in Example 1, except that the glass powder was changed to P₂O₅-ZnO-Y₂O₃-based glass powder whose particle shape is substantially spherical, average particle diameter is 2.1 µm and softening point is 430°C (P₂O₅: 61%, ZnO: 35%, Y₂O₃: 4%).
The surface at the side where the composition for forming an n-type diffusion layer was applied exhibited a sheet resistance of 25 Ω/□ and the formation of an n-type diffusion layer through diffusion of P. On the other hand, the rear surface exhibited an unmeasurable sheet resistance and substantively no formation of an n-type diffusion layer.

### [Example 10]

An n-type diffusion layer was formed in the same manner as in Example 1, except that the glass powder was changed to P₂O₅-ZnO-K₂O-based glass powder whose particle shape is substantially spherical, average particle diameter is 2.4 µm and softening point is 395°C (P₂O₅: 61%, ZnO: 35%, K₂O: 4%).
The surface at the side where the composition for forming an n-type diffusion layer was applied exhibited a sheet resistance of 19 Ω/□ and the formation of an n-type diffusion layer through diffusion of P. On the other hand, the rear surface exhibited an unmeasurable sheet resistance and substantively no formation of an n-type diffusion layer.

### [Example 11]

An n-type diffusion layer was formed in the same manner as in Example 1, except that the glass powder was changed to P₂O₅-ZnO-K₂O-Na₂O-based glass powder whose particle shape is substantially spherical, average particle diameter is 3.0 µm and softening point is 406°C (P₂O₅: 62%, ZnO: 35%, K₂O: 2%, Na₂O: 1%).
The surface at the side where the composition for forming an n-type diffusion layer was applied exhibited a sheet resistance of 21 Ω/□ and the formation of an n-type diffusion layer through diffusion of P. On the other hand, the rear surface exhibited an unmeasurable sheet resistance and substantively no formation of an n-type diffusion layer.

### [Example 12]

An n-type diffusion layer was formed in the same manner as in Example 1, except that the glass powder was changed to P₂-O₅₋CaO-based glass powder whose particle shape is substantially spherical, average particle diameter is 2.8 µm and softening point is 470°C (P₂O₅: 83%, CaO: 17%).
The surface at the side where the composition for forming an n-type diffusion layer was applied exhibited a sheet resistance of 14 Ω/□ and the formation of an n-type diffusion layer through diffusion of P. On the other hand, the rear surface exhibited an unmeasurable sheet resistance and substantively no formation of an n-type diffusion layer.

### [Example 13]

An n-type diffusion layer was formed in the same manner as in Example 7, except that the composition for forming an n-type diffusion layer was applied to a half surface of a silicon substrate (5 cm × 5 cm; the same size shall apply to the following Examples) instead of the entire surface thereof, and the set temperature of the electric furnace was 950°C.
The surface of the portion where the composition for forming an n-type diffusion layer was applied exhibited a sheet resistance of 38 Ω/□ and the formation of an n-type diffusion layer through diffusion of P. On the other hand, the surface of the portion where the composition for forming an n-type diffusion layer was not applied exhibited an unmeasurable sheet resistance and no formation of an n-type diffusion layer, and the portion where the composition for forming an n-type diffusion layer was applied exhibited selective formation of an n-type diffusion layer. Further, the rear surface exhibited an unmeasurable sheet resistance and substantively no formation of an n-type diffusion layer.

### [Example 14]

An n-type diffusion layer was formed in the same manner as in Example 8, except that the composition for forming an n-type diffusion layer was applied to a half surface of the silicon substrate surface instead of the entire surface thereof, and the set temperature of the electric furnace was 950°C.
The surface of the portion where the composition for forming an n-type diffusion layer was applied exhibited a sheet resistance of 45 Ω/□ and the formation of an n-type diffusion layer through diffusion of P. On the other hand, the surface of the portion where the composition for forming an n-type diffusion layer was not applied exhibited an unmeasurable sheet resistance and no formation of an n-type diffusion layer, and the portion where the composition for forming an n-type diffusion layer was applied exhibited selective formation of an n-type diffusion layer. Further, the rear surface exhibited an unmeasurable sheet resistance and substantively no formation of an n-type diffusion layer.

### [Example 15]

An n-type diffusion layer was formed in the same manner as in Example 9, except that the composition for forming an n-type diffusion layer was applied to a half surface of the silicon substrate surface instead of the entire surface thereof, and the set temperature of the electric furnace was 950°C.
The surface of the portion where the composition for forming an n-type diffusion layer was applied exhibited a sheet resistance of 35 Ω/□ and the formation of an a-type diffusion layer through diffusion of P. On the other hand, the surface of the portion where the composition for forming an n-type diffusion layer was not applied exhibited an unmeasurable sheet resistance and no formation of an n-type diffusion layer, and the portion where the composition for forming an n-type diffusion layer was applied exhibited selective formation of an n-type diffusion layer. Further, the rear surface exhibited an unmeasurable sheet resistance and substantively no formation of an n-type diffusion layer.

### [Example 16]

An n-type diffusion layer was formed in the same manner as in Example 10, except that the composition for forming an n-type diffusion layer was applied to a half surface of the silicon substrate surface instead of the entire surface thereof, and the set temperature of the electric furnace was 950°C.
The surface of the portion where the composition for forming an n-type diffusion layer was applied exhibited a sheet resistance of 42 Ω/□ and the formation of an n-type diffusion layer through diffusion of P. On the other hand, the surface of the portion where the composition for forming an n-type diffusion layer was not applied exhibited an unmeasurable sheet resistance and no formation of an n-type diffusion layer, and the portion where the composition for forming an n-type diffusion layer was applied exhibited selective formation of an n-type diffusion layer. Further, the rear surface exhibited an unmeasurable sheet resistance and substantively no formation of an n-type diffusion layer.

### [Example 17]

An n-type diffusion layer was formed in the same manner as in Example 11, except that the composition for forming an n-type diffusion layer was applied to a half surface of the silicon substrate surface instead of the entire surface thereof, and the set temperature of the electric furnace was 950°C.
The surface of the portion where the composition for forming an n-type diffusion layer was applied exhibited a sheet resistance of 50 Ω/□ and the formation of an n-type diffusion layer through diffusion of P. On the other hand, the surface of the portion where the composition for forming an n-type diffusion layer was not applied exhibited an unmeasurable sheet resistance and no formation of an n-type diffusion layer, and the portion where the composition for forming an n-type diffusion layer was applied exhibited selective formation of an n-type diffusion layer. Further, the rear surface exhibited an unmeasurable sheet resistance and substantively no formation of an n-type diffusion layer.

### [Example 18]

An n-type diffusion layer was formed in the same manner as in Example 12, except that the composition for forming an n-type diffusion layer was applied to a half surface of the silicon substrate surface instead of the entire surface thereof, and the set temperature of the electric furnace was 950°C.
The surface of the portion where the composition for forming an n-type diffusion layer was applied exhibited a sheet resistance of 38 Ω/□ and the formation of an n-type diffusion layer through diffusion of P. On the other hand, the surface of the portion where the composition for forming an n-type diffusion layer was not applied exhibited an unmeasurable sheet resistance and no formation of an n-type diffusion layer, and the portion where the composition for forming an n-type diffusion layer was applied exhibited selective formation of an n-type diffusion layer. Further, the rear surface exhibited an unmeasurable sheet resistance and substantively no formation of an n-type diffusion layer.

### [Example 19]

An n-type diffusion layer was formed in the same manner as in Example 1, except that 10 g of P₂O₅-SiO₂ -CaO-based glass powder whose particle shape is substantially spherical, average particle diameter is 1.7 µm and softening point is 756°C (P₂O₅: 30%, SiO₂: 60%, CaO: 10%), 4 g of ethylcellulose and 86 g of α-terpinenol were mixed.
The surface at the side where the composition for forming an n-type diffusion layer was applied exhibited a sheet resistance of 30 Ω/□ and the formation of an n-type diffusion layer through diffusion of P. On the other hand, the rear surface exhibited an unmeasurable sheet resistance of 1,000,000 Ω/□ or higher and substantively no formation of an n-type diffusion layer.

### [Comparative Example 1]

20 g of ammonium dihydrogen phosphate (NH₄H₂PO₄) powder, 3 g of ethylcellulose, and 7 g of 2-(2-butoxyethoxy)ethyl acetate were mixed and made into a paste to prepare a composition for forming an n-type diffusion layer.
Next, the prepared paste was applied to a p-type silicon substrate surface by screen printing, and dried on a hot plate at 150°C for 5 minutes. Subsequently, a thermal diffusion treatment was carried out in an electric furnace at 1000°C for 10 minutes. Then, in order to remove the glass layer, the substrate was dipped in hydrofluoric acid for 5 minutes, followed by washing with running water and drying.

The surface at the side where the composition for forming an n-type diffusion layer was applied exhibited a sheet resistance of 14 Ω/□ and the formation of an n-type diffusion layer through diffusion of P (phosphorus). On the other hand, the rear surface exhibited a sheet resistance of 50 Ω/□ and also exhibited the formation of an n-type diffusion layer.

### [Comparative Example 2]

1 g of ammonium dihydrogen phosphate (NH₂H₂PO₄) powder, 7 g of pure water, 0.7 g of polyvinyl alcohol, and 1.5 g of isopropyl alcohol were mixed to form a solution, thereby preparing a composition for forming an n-type diffusion layer..
Next, the prepared solution was applied to a p-type silicon substrate surface by a spin coater (2000 rpm, 30 sec), and dried on a hot plate at 150°C for 5 minutes. Subsequently, a thermal diffusion treatment was carried out in an electric furnace at 1000°C for 10 minutes. Then, in order to remove the glass layer, the substrate was dipped in hydrofluoric acid for 5 minutes, followed by washing with running water and drying.

The surface at the side where the composition for forming an n-type diffusion layer was applied exhibited a sheet resistance of 10 Ω/□ and the formation of an n-type diffusion layer through diffusion of P (phosphorus). On the other hand, the rear surface exhibited a sheet resistance of 100 Ω/□ and also exhibited the formation of an n-type diffusion layer.

### [Comparative Example 3]

1 g of phosphoric acid, 9 g of SiO₂ powder, 3 g of polyvinyl alcohol and 90 g of pure water were mixed to form a paste, thereby preparing a composition for forming an n-type diffusion layer..
Next, the prepared paste was applied to a p-type silicon substrate surface by a screen printing, and dried on a hot plate at 150°C for 5 minutes. Subsequently, a thermal diffusion treatment was carried out in an electric furnace at 1000°C for 10 minutes. Then, in order to remove the glass layer, the substrate was dipped in hydrofluoric acid for 5 minutes, followed by washing with running water and drying.
The surface at the side where the composition for forming an n-type diffusion layer was applied exhibited a sheet resistance of 30 Ω/□ and the formation of an n-type diffusion layer through diffusion of P (phosphorus). On the other hand, the rear surface exhibited a sheet resistance of 60 Ω/□ and also exhibited the formation of an n-type diffusion layer.

The foregoing description of the embodiments of the present invention has been provided for the purposes of illustration and description. It is not intended to be exhaustive or to limit the present invention to the precise forms disclosed. Obviously, many modifications and variations will be apparent to practitioners skilled in the art. The embodiments were chosen and described in order to best explain the principles of the present invention and its practical applications, thereby enabling others skilled in the art to understand the present invention for various embodiments and with the various modifications as are suited to the particular use contemplated. It is intended that the scope of the present invention be defined by the following claims and their equivalents.
All publications, patent applications, and technical standards mentioned in this specification are herein incorporated by reference to the same extent as if each individual publication, patent application, or technical standard was specifically and individually indicated to be incorporated by reference.

## Claims

1. A composition comprising a donor element-containing glass powder and a dispersion medium.

2. The composition according to claim 1, wherein the donor element is at least one selected from phosphorous (P) and antimony (Sb).

3. The composition according to claim 1 or 2, wherein the donor element-containing glass powder contains:
at least one donor element-containing material selected from P₂O₃, P₂O₅ and Sb₂O₃; and
at least one glass component material selected from SiO₂, K₂O, Na₂O, Li₂O, BaO, SrO, CaO, MgO, BeO, ZnO, PbO, CdO, V₂O₅, SnO, ZrO₂ and MoO₃.

4. The composition according to any one of claims 1 to 3, further comprising a metallic element that crystallizes through reaction with the glass powder.

5. The composition according to claim 4, wherein the metallic element that crystallizes through reaction with the glass powder is at least one selected from silver (Ag), silicon (Si), copper (Cu), iron (Fe), zinc (Zn) and manganese (Mn).

6. The composition according to any one of claims 1 to 5, wherein the composition exhibits paste state.

7. The composition according to any one of claims 1 to 6, wherein the dispersion medium comprises a binder and a solvent.

8. A use of the composition according to any one of claims 1 to 7 for forming an n-type diffusion layer on a semiconductor substrate.

9. A use of the composition according to anyone of claims 1 to 7 in the manufacture of a solar battery.

10. A method for forming an n-type diffusion layer, comprising:
applying, on a semiconductor substrate, the composition of any one of claims 1 to 7; and
conducting a thermal diffusion treatment.

11. A method for producing a photovoltaic cell, comprising:
applying, on a semiconductor substrate, the composition of any one of claims 1 to 7; and
subjecting the substrate to a thermal diffusion treatment, thereby forming an n-type diffusion layer.

12. The method for producing a photovoltaic cell according to claim 11, comprising the steps of applying the composition according to any one of claims 1 to 7 on the textured surface of a silicon substrate, followed by optional drying.

13. The method for producing a photovoltaic cell according to claim 12, wherein the silicon substate having a textured surface structure is formed by removing the damaged surface layer from a silicon substrate sliced from an ingot and etching the thus obtained silicon substrate to form a textured surface structure.

14. The method for producing a photovoltaic cell according to claim 12 or 13, which comprises subsequent to applying the composition on the textured surface and optional drying the following steps:
(viii) thermal diffusion treatment, preferably at a temperature of 600 to 1200 °C, to form a glass layer and an n-type diffusion layer beneath the glass layer;
(ix) removing the glass layer by etching;
(x) forming a p⁺-type diffusion layer on the rear surface of the substrate;
(xi) forming an antireflective film over the n-type diffusion layer;
(xii) forming surface electrode on the antireflective film;
(xiii) forming rear surface electrode on the p⁺-type diffusion layer; and
(xiv) sintering to establish electrical connection between the surface electrode and the silicon substrate.

15. A use of the composition according to any one of claims 1 to 7 in the production of a back contact-type photovoltaic cell.

16. A method for forming an n-type diffusion region in a semiconductor comprising the steps of:
1) coating a portion of a semiconductor substrate with a layer of a composition comprising a dispersion of donor element-containing glass particles in a dispersion medium; and
2) heating the coated semiconductor substrate to a temperature sufficient to cause donor element diffusion from the glass into the semiconductor substrate so as to form an n-type diffusion region in the semiconductor substrate.
